(19) Europäisches Patentamt
European Patent Office
Office européen des brevets

(11)   EP 3 407 078 B1

(12)   **EUROPEAN PATENT SPECIFICATION**

(45) Date of publication and mention
of the grant of the patent:
**27.11.2019  Bulletin 2019/48**

(51) Int Cl.:
*G01R 33/07* *(2006.01)*     *G01R 33/00* *(2006.01)*

(21) Application number: **18169905.9**

(22) Date of filing: **27.04.2018**

(54) **MAGNETIC SENSOR CIRCUIT**

MAGNETSENSORSCHALTUNG

CIRCUIT DE CAPTEUR MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.04.2017  JP 2017090393**

(43) Date of publication of application:
**28.11.2018  Bulletin 2018/48**

(73) Proprietor: **ABLIC Inc.**
**Chiba-shi, Chiba (JP)**

(72) Inventor: **IRIGUCHI, Masao**
**Chiba-chi, Chiba (JP)**

(74) Representative: **Miller Sturt Kenyon**
**9 John Street**
**London WC1N 2ES (GB)**

(56) References cited:
**EP-A1- 2 843 435       WO-A1-2016/047149**
**GB-A- 904 521          US-A1- 2010 109 661**
**US-A1- 2013 057 084**

**Description**

BACKGROUND OF THE INVENTION

Field of the Invention

The present invention relates to a magnetic sensor circuit.

Background Art

A magnetic sensor circuit using a magnetoelectric conversion element (Hall element, for example) has been used in various electronic devices as a non-contact type sensor. For example, the magnetic sensor circuit is used in a folding type cellular phone. The magnetic sensor circuit detects the opening and closing of the cellular phone when a magnetic field exceeds a certain constant threshold value. The magnetic sensor circuit includes a Hall element and a signal processing circuit which processes a signal provided from the Hall element. An offset voltage may however occur in the Hall element or the signal processing circuit. When the offset voltage occurs, detection of the strength of a magnetic field fails. When the detected strength of the magnetic field is wrong, detection of the position of a magnet or the like generating the magnetic field fails. Hence, a signal processing system using the Hall element is required to process a signal with satisfactory accuracy. When the magnetoelectric conversion element is of the Hall element, output of a voltage which is not zero has been known in a zero magnetic field state in which no magnetic field is applied.
The offset voltage of the Hall element occurs due to variation in manufacturing the Hall element, a stress, an influence of a magnetic field around the Hall element, etc. As a method of suppressing the offset voltage of the Hall element, there has been known a SPINNING CURRENT method. For example, in a Hall element having a square shape in which terminals are respectively provided at the four corners, when a drive current flows to the opposite terminals at 0 degrees (along a diagonal) and a drive current flows to the opposite terminals at 90 degrees (along the other diagonal), regarding voltages generated by application of the magnetic field, signal voltages can be made into in-phase signals provided that the offset voltages are reverse phase signals. The offset voltage can be reduced by adding these signals. Further, in the SPINNING CURRENT method, there is also a case where in order to perform signal processing with satisfactory accuracy, four signals obtained respectively by supplying currents from the opposite terminals at 0 degrees, the opposite terminals at 90 degrees, the opposite terminals at 180 degrees, and the opposite terminals at 270 degrees in the square-shaped Hall element are respectively added to reduce the offset voltage.
For example, the relation between the strength of an applied magnetic field and a differential output voltage of signals provided from the Hall element can be represented by the following equation (1):
[Equation 1]

$$V_{HOUT} = S_I \cdot I_{drive} \cdot B \qquad \cdot \cdot \cdot (1)$$

In the equation (1) VHOUT is a differential output voltage [mVolt] of the Hall element. SI is a magnetic field conversion coefficient per unit current·and per unit magnetic field [mVolt/mA/mT]. Idrive is a flow of current [mA] in the Hall element. In other words, Idrive is the amount of a current which drives the Hall element. B is the strength [mT] of a magnetic field to be applied to the Hall element.
Further, the resistance that the Hall element has is given by Rhall [kohm], and the applied voltage to the Hall element is Vdd [Volt], the above-described Idrive can be given by the following equation (2):
[Equation 2]

$$I_{drive} = \frac{V_{dd}}{R_{hall}} \qquad \cdot \cdot \cdot (2)$$

The following equation (3) is derived by substituting the above-described equation (2) into the equation (1):
[Equation 3]

$$V_{HOUT} = S_I \cdot \frac{V_{dd}}{R_{hall}} \cdot B \qquad \cdot \cdot \cdot (3)$$

Here, the resistance of the Hall element Rhall may change due to a stress to the package of the magnetic sensor circuit, or a stress caused by a long-term change in the package, etc. Change of the Rhall changes the magnetoelectric conversion coefficient. The change in the magnetoelectric conversion coefficient changes the differential output voltage of the signals provided from the Hall element. That is, a change in the resistance value of Rhall comes to a change in the magnetoelectric conversion coefficient, so that the accuracy of the signal processing circuit of the magnetic sensor circuit having the Hall element degenerates.

There has been disclosed in Japanese Patent Application Laid-Open No. 2014-517919, a configuration in which a magnetic field conversion coefficient of each Hall element is calibrated by a magnetic field generated from a coil. Specifically, coils wound in directions reverse to each other are arranged in two Hall elements respectively. A magnetic field is generated from each coil by a current flowing in the coil. The magnetic field generated from the coil is a magnetic field for calibrating the sensitivity of the Hall element. Each of the Hall elements described in Japanese Patent Application Laid-Open No. 2014-517919 is configured to change a drive current driving the Hall element to thereby calibrate the magnetic conversion coefficient thereof.

There has been disclosed in U.S. Patent 8723515, a configuration for compensating of a stress change in a vertical Hall element. The vertical Hall element detects a magnetic field in a horizontal direction to a magnetoelectric conversion surface. In this configuration, resistive bodies which change in resistance value depending on the stress are arranged in prescribed directions to compensate for the stress change in the vertical Hall element. A drive current which drives the Hall element is changed by a change in the resistance value of each resistive body. Correspondence between the drive current and the characteristic of a resistance value that the Hall element has is used to calibrate a magnetic field conversion coefficient.

US 2013/057084 discloses a hall plate switching system including: a hall plate that generates first hall voltage at both ends of a first node and a third node facing each other and generates second hall voltage at both ends of a second node and a fourth node facing each other; a first switch unit that is connected with the first node and the second node and controls on/off of current flowing in the first node and the second node; a second switch unit that is connected with the third node and the fourth node and controls on/off of current flowing in the third node and the fourth node; and a resistor unit that is connected with the second switch unit and reduces trans-conductance of the first switch unit and the second switch unit.

US 2010/109661 relates to a hall-effect switching system which comprises a hall-effect switch, a voltage comparison module, and a resistance bypass module. The voltage comparison module compares a supply voltage and a reference voltage. The resistance bypass module selectively adjusts a voltage output to the hall-effect switch based on the comparison.

## SUMMARY OF THE INVENTION

In the above-described related art configuration, the magnetic sensor circuit is required to have additional elements such as a coil, etc. when compensating for the change in the sensitivity of the magnetoelectric conversion element due to a stress or stress. An area for mounting the magnetic sensor circuit is thereby large. That is, it is difficult to miniaturize the magnetic sensor circuit.

An object of the present invention is to provide a small-sized magnetic sensor circuit which compensates a magnetoelectric conversion coefficient.

In order to solve such problems in the related art, a magnetic sensor circuit of the present invention is configured as follows.

In accordance with an aspect of the present invention, there is provided a magnetic sensor circuit as defined in claim 1.

According to the present invention, a small-sized magnetic sensor circuit which compensates a magnetoelectric conversion coefficient is provided.

## BRIEF DESCRIPTION OF THE DRAWINGS

Embodiments of the present invention will now be described by way of further example only and with reference to the accompanying drawings, in which:

FIG. 1 is a circuit diagram of a magnetic sensor circuit according to a first embodiment of the present invention;
FIG. 2 is a circuit diagram illustrating two phases of the magnetic sensor circuit;
FIG. 3 is a diagram illustrating one example of a temperature characteristic of a resistance value of a Hall element and a temperature characteristic of a resistor;
FIG. 4 is a diagram illustrating one example of a current value of a drive current in the Hall element;
FIG. 5 is a circuit diagram illustrating one example of the configuration of a magnetic sensor circuit according to a second embodiment of the present invention; and

FIG. 6 is a circuit diagram of a reference voltage generator.

DESCRIPTION OF THE EMBODIMENTS

Embodiments of the present invention will hereinafter be described with reference to the accompanying drawings.

[First Embodiment]

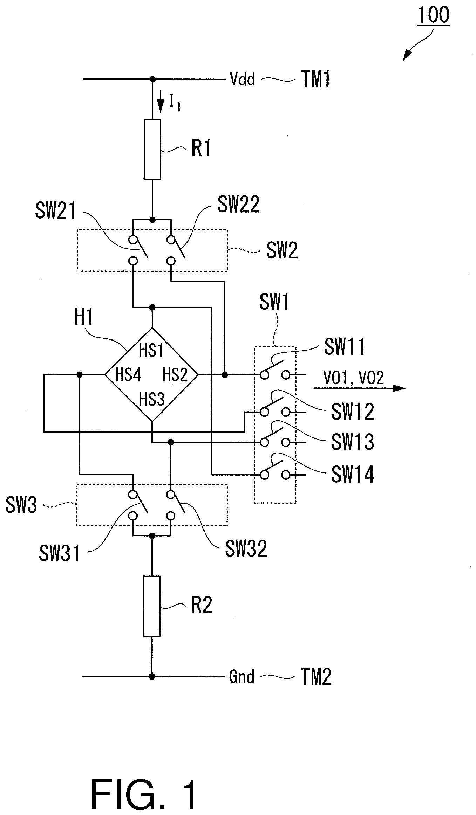

A magnetic sensor circuit configuration according to a first embodiment will be described with reference to FIG. 1.

FIG. 1 is a circuit diagram of a magnetic sensor circuit 100 according to the first embodiment.

The magnetic sensor circuit 100 according to the first embodiment has a power supply terminal TM1, a ground terminal TM2, a resistor R1, a resistor R2, a first switch circuit SW1, a second switch circuit SW2, a third switch circuit SW3, and a Hall element H1. The Hall element H1 is one example of a magnetoelectric conversion element.

The first switch circuit SW1 has a first switch SW11, a first switch SW12, a first switch SW13, and a first switch SW14. The first switch circuit SW1 is an example of a switch circuit.

The second switch circuit SW2 has a second switch SW21, a second switch SW22. The second switch circuit SW2 is an example of a switch circuit.

The third switch circuit SW3 has a third switch SW31 and a third switch SW32. The third switch circuit SW3 is an example of a switch circuit.

The Hall element H1 has a terminal HS1, a terminal HS2, a terminal HS3, and a terminal HS4. In the following description, the terminals HS1 through HS4 are also simply described as terminals HS when the terminals are not distinguished from each other.

A drive voltage is applied from a power supply to the power supply terminal TM1. Since the drive voltage of a voltage Vdd is applied to the power supply terminal TM1, a current I1 is supplied to the power supply terminal TM1 from the power supply. The current I1 supplied from the power supply terminal TM1 flows to the ground terminal TM2 through the resistor R1 and the Hall element H1.

The resistor R1 has the first temperature characteristic which is a prescribed temperature characteristic. The temperature characteristic is a characteristic of a change in the resistance value of the resistor R1 according to a change in temperature. The resistor R2 has the first temperature characteristic as with the resistor R1. In the present embodiment, a temperature coefficient of the first temperature characteristic is smaller than the temperature coefficient of the resistance value that the Hall element H1 has. That is, in the resistor R1 and R2, the change in its resistance value due to the temperature change is smaller than the temperature change in the resistance value that the Hall element H1 has.

The first switch circuit SW1 outputs signals provided from any two of the plural terminals HS as a differential voltage. The signals provided from the two terminals are a signal VO1 and a signal VO2. The signals VO1 and VO2 are signals opposite in phase from each other.

The first switch circuit SW1 is connected to an unillustrated signal processing circuit. The signal processing circuit applies signal processing to the signals VO1 and VO2 supplied from the first switch circuit SW1. Specifically, the signal processing circuit is a circuit such as an amplifier, a comparator, an AD converter (Analog-to-digital converter), or the like.

The second switch circuit SW2 makes the current I1 flow in any one of the plural terminals. Specifically, the second switch circuit SW2 makes the current I1 flow in either one of the terminal HS1 of the Hall element H1 and the terminal HS2 of the Hall element H1.

The third switch circuit SW3 makes the current I1 flow out from any one of the plural terminals HS.

In the Hall element H1 the functions of the terminals HS can be switched by the above-described spinning current method. Specifically, the terminals HS of the Hall element H1 respectively include a positive-electrode power supply terminal function, a negative-electrode power supply terminal function, a positive phase signal output function of outputting a positive phase signal, and a negative phase signal output function of outputting a negative phase signal. The first switch circuit SW1, the second switch circuit SW2, and the third switch circuit SW3 change the functional assignment of the respective terminals HS included in the Hall element H1 to thereby switch the direction of the current in the Hall element with respect to its signal output terminal. Further, a certain connected state of the magnetic sensor circuit 100 is also described as a phase.

The Hall element H1 is driven by the drive voltage applied to a voltage supply terminal. The current I1 applied to the voltage supply terminal flows into the Hall element H1. In the present embodiment, the voltage supply terminal is the terminal HS1 or the terminal HS2. The current I1 that has driven the Hall element H1 is made flow out from a ground terminal. The ground terminal is the terminal HS3 where the voltage supply terminal is the terminal HS1. The ground terminal is the terminal HS4 where the voltage supply terminal is the terminal HS2. In the present embodiment, the Hall element H1 is driven in two phases.

The resistor R1 is connected to the power supply terminal TM1 and the second switch circuit SW2. In the following description, the terminal connected to the power supply terminal TM1, of the terminals of the resistor R1 is also described as a first terminal of the resistor R1. Further, the terminal connected to the second switch circuit SW2, of the terminals of the resistor R1 is also described as a second terminal of the resistor R1.

The resistor R2 is connected to the ground terminal TM2 and the third switch circuit SW3. In the following description, the terminal connected to the ground terminal TM2, of the terminals of the resistor R2 is also described as a first terminal of the resistor R2. Further, the terminal connected to the third switch circuit SW3, of the terminals of the resistor R2 is also described as a second terminal of the resistor R2.

[Two Phases of Magnetic Sensor Circuit 100]

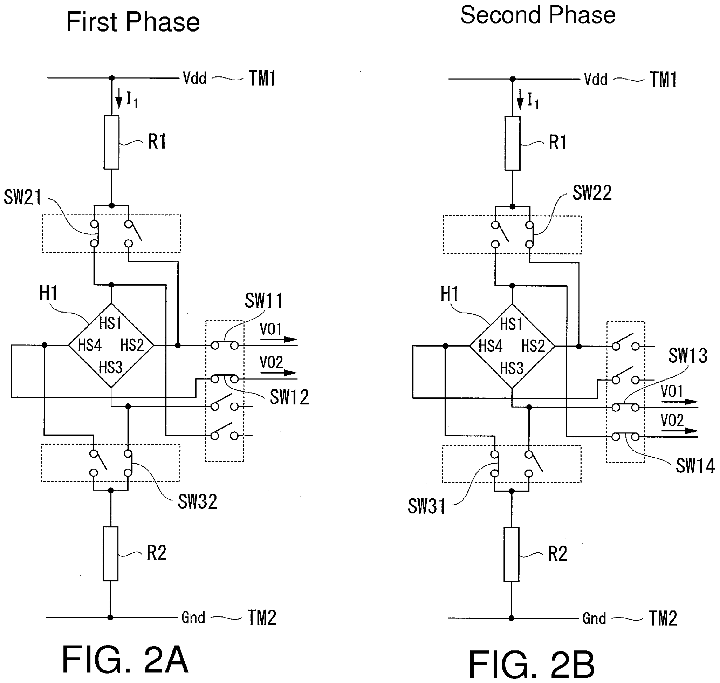

The two phases of the magnetic sensor circuit 100 will next be described with reference to FIG. 2.

FIG. 2 is a circuit diagram illustrating the two phases of the magnetic sensor circuit 100.

FIG. 2A is a circuit diagram illustrating the magnetic sensor circuit 100 in a state of a first phase. FIG. 2B is a circuit diagram illustrating the magnetic sensor circuit 100 in a state of a second phase.

[Circuit in First Phase of Magnetic Sensor Circuit 100]

The first switch SW11 is connected to the terminal HS2 of the Hall element H1 in the first phase.

The first switch SW12 is connected to the terminal HS4 of the Hall element H1 in the first phase.

The first switch SW13 is made open in the first phase.

The first switch SW14 is made open in the first phase.

The second switch SW21 is connected to the second terminal of the resistor R1 and the terminal HS1 of the Hall element H1 in the first phase.

The second switch SW22 is made open in the first phase.

The third switch SW31 is made open in the first phase.

The third switch SW32 is connected to the second terminal of the resistor R2 and the terminal HS3 of the Hall element in the first phase.

The Hall element H1 is driven by the current I1 supplied from the terminal HS1 in the first phase. The Hall element H1 makes the current I1 flow out from the terminal HS3 in the first phase. The Hall element H1 supplies the signal VO1 from the terminal HS2 to the first switch SW11 in the first phase. The Hall element H1 supplies the signal VO2 from the terminal HS4 to the first switch SW12 in the first phase.

[Circuit in Second Phase of Magnetic Sensor Circuit 100]

The first switch SW11 is made open in the second phase.

The first switch SW12 is made open in the second phase.

The first switch SW13 is connected to the terminal HS3 of the Hall element H1 in the second phase.

The first switch SW14 is connected to the terminal HS1 of the Hall element H1 in the second phase.

The second switch SW21 is made open in the second phase.

The second switch SW22 is connected to the second terminal of the resistor R1 and the terminal HS2 of the Hall element H1 in the second phase.

The third switch SW31 is connected to the second terminal of the resistor R2 and the terminal HS4 of the Hall element H1 in the second phase.

The third switch SW32 is made open in the second phase.

The Hall element H1 is driven by the current I1 supplied from the terminal HS2 in the second phase. The Hall element H1 makes the current I1 flow out from the terminal HS4 in the second phase. The Hall element H1 supplies the signal VO1 from the terminal HS3 to the first switch SW13 in the second phase. The Hall element H1 supplies the signal VO2 from the terminal HS1 to the first switch SW14 in the second phase.

[Compensation for Temperature Coefficient of Hall Element H1]

A description will be made here about a temperature coefficient of the Hall element H1, which is compensated by the resistors R1 and R2.

Equation (4) indicates changes in the resistance values of the resistors R1 and R2 due to a temperature change.
[Equation 4]

$$Rb1 = b1 \cdot [1 + \beta_1(T - 25) + \beta_2(T - 25)^2] \equiv b1 \cdot Rtb$$
$$Rb2 = b2 \cdot Rtb \qquad\qquad (4)$$

Where b1 is a basic resistance value of the resistor R1, b2 is a basic resistance value of the resistor R2, Rtb is a temperature coefficient of each of the resistors R1 and R2, $\beta_1$ is a primary temperature coefficient proportional to the first power of the temperature, of temperature coefficients, and $\beta_2$ is a secondary temperature coefficient proportional to the second power of the temperature, of the temperature coefficients.

As described above, the power supply terminal TM1 is supplied with the voltage of Vdd. Here, the voltage applied to the Hall element H1 can be calculated by a resistance Rhall that the above-described Hall element H1 has, and the voltage division ratio of Rb1 and Rb2 illustrated in the equation (4). A differential output voltage of the Hall element H1 is represented by equation (5):

[Equation 5]

$$V_{HOUT} = S_I \cdot \frac{V_{dd}}{R_{hall} + Rb1 + Rb2} \cdot B = S_I \cdot \frac{V_{dd}}{R_{hall} + (b1 + b2)Rtb} \cdot B$$

$$\cdots (5)$$

Here VHOUT is a differential output voltage of the Hall element [mVolt], and SI is a magnetic field conversion coefficient per unit current·unit magnetic field [mVolt/mA/mT].

Further, a magnetoelectric conversion coefficient KH of the Hall element H1 can be expressed by equation (6):

[Equation 6]

$$KH = S_I \cdot \frac{V_{dd}}{R_{hall} + (b1 + b2)Rtb} \qquad \cdots (6)$$

As expressed in the equation (6), the magnetoelectric conversion coefficient KH has a term (b1+b2)Rtb in its denominator, which suppresses an influence due to a change in Rhall. Here, the term of (b1+b2)Rtb is a value obtained by adding a value made by multiplying the basic resistance value of the resistor R1 and the temperature coefficient of the resistor R1 and a value made by multiplying the basic resistance value of the resistor R2 and the temperature coefficient of the resistor R2.

Next, an amount of change ΔKH in the magnetoelectric conversion coefficient KH where Rhall is increased by a stress is expressed in equation (7):

[Equation 7]

$$\Delta KH = S_1 \cdot \frac{V_{dd}}{R_{hall} + \Delta R_{hall} + (b1 + b2)Rtb} - S_1 \cdot \frac{V_{dd}}{R_{hall} + (b1 + b2)Rtb}$$
$$= S_1 V_{dd} \left[ \frac{-\Delta R_{hall}}{(R_{hall} + (b1 + b2)Rtb)^2 + \Delta R_{hall}(R_{hall} + (b1 + b2)Rtb)} \right] \qquad (7)$$

where the second term of the denominator is sufficiently smaller than the first term thereof,

$$\Delta KH \approx S_1 V_{dd} \frac{-\Delta R_{hall}}{(R_{hall} + (b1 + b2)Rtb)^2}$$

Here ΔRhall is an amount of change in Rhall increased by the stress.

As expressed in the equation (7), a change in the sensitivity due to the stress can be suppressed by the existence of Rtb being a temperature coefficient term of a resistance in the denominator. Here, when ΔRhall included in the equation (7) is a positive value, the magnetoelectric conversion coefficient KH changes in a negative direction. In the case of the magnetoelectric conversion coefficient KH, however, the amount of its change is suppressed by the term of (b1+b2)Rtb.

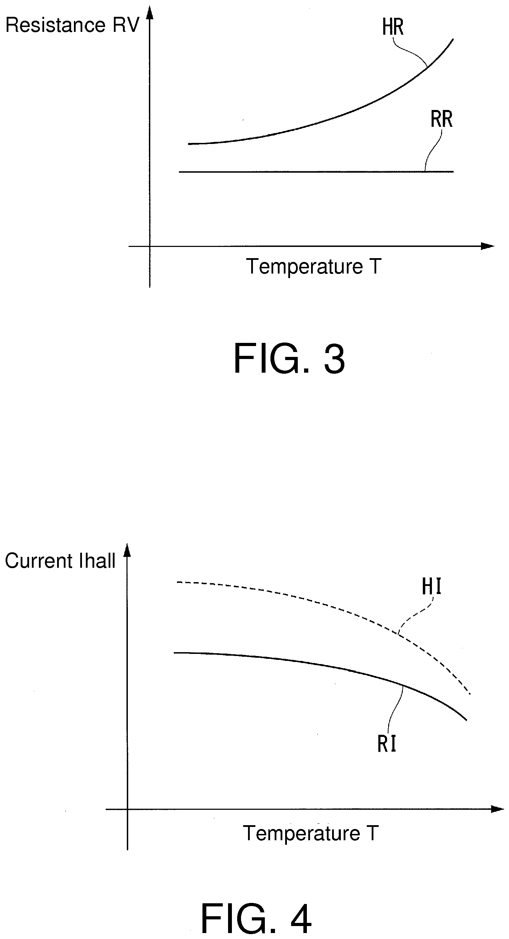

Now, referring to FIGS. 3 and 4, there is illustrated one example of a temperature characteristic of the resistance Rhall that the Hall element has, a temperature characteristic of the resistor R, and a current value of a drive current in the Hall element H1.

FIG. 3 is a diagram illustrating one example of the temperature characteristic of the resistance Rhall that the Hall element has, and the temperature characteristic of the resistor R.

A line HR illustrated in FIG. 3 is one example of the temperature characteristic of the resistance Rhall that the Hall element has. When a temperature T rises, the resistance Rhall that the Hall element has also rises. A line RR illustrated in FIG. 3 is one example of the temperature characteristic of the resistor. A change in the resistance value due to a change in temperature T is smaller than at the resistance Rhall that the Hall element has.

FIG. 4 is a diagram illustrating one example of the current value of the drive current in the Hall element H1.

A line HI illustrated in FIG. 4 is one example of a drive current Ihall accompanying a temperature T change in in the resistance Rhall that the Hall element has. When the temperature T rises, the drive current Ihall is lowered. This is because the resistance Rhall that the Hall element has is increased with the rise in the temperature T. A line RI illustrated in FIG. 4 is one example of the drive current Ihall in the Hall element H1 of the magnetic sensor circuit 100 having the resistor R1 or R2. It is understood that a temperature change in Ihall represented by the line RI is smaller in its amount of change than a temperature change in Ihall represented by the line HI.

[Summary of First Embodiment]

As described above, the magnetic sensor circuit 100 has the resistor R1, the resistor R2, and the Hall element H1. The resistor R1 and the resistor R2 are capable of, by having the first temperature characteristic, suppressing the amount of change in the resistance value accompanying the temperature change in the resistance Rhall that the Hall element H1 has. Thus, the magnetic sensor circuit 100 is capable of suppressing an influence on the signal provided from the Hall element H1 by stress such as a stress or the like. The magnetic sensor circuit 100 is capable of compensating for the magnetoelectric conversion coefficient of the Hall element H1 by the resistors R1 and R2 each having the first temperature characteristic. Since the magnetic sensor circuit 100 compensates the magnetoelectric conversion coefficient by using the down-sizable element such as the resistor or the like, a small-sized magnetic sensor circuit can be provided.

Incidentally, although the above description has been made to the configuration in which the Hall element H1 is switched in the two phases, the present embodiment is not limited to that. The magnetic sensor circuit 100 may be switched to four phases. Further, the magnetic sensor circuit 100 may be provided with a plurality of Hall elements to thereby spatially suppress offset voltages among the Hall elements. In other words, the second switch circuit and the third switch circuit are not essential to the magnetic sensor circuit 100.

Also, although the above description has been made about the configuration in which the magnetic sensor circuit 100 has the resistor R1 and the resistor R2, the present embodiment is not limited to it. The magnetic sensor circuit 100 may be equipped with one of the resistor R1 and the resistor R2.

Further, although the above description has been made about the case where the temperature coefficient of the first temperature characteristic is smaller than the temperature coefficient of the resistance value that the Hall element H1 has, the present embodiment is not limited to it. When the temperature coefficient of the first temperature characteristic is smaller than the temperature coefficient of the resistance value that the Hall element H1 has, it is possible to more suppress the change in the magnetoelectric conversion coefficient KH due to the temperature change. Thus, the magnetic sensor circuit 100 is capable of narrowing a width for temperature compensation.

Incidentally, although the above description has been made about the case where the magnetoelectric conversion element is the Hall element, the present embodiment is not limited to it. The magnetoelectric conversion element may be a magnetoresistance sensor. Further, although the description has been made about the case where the above-mentioned Hall element H1 is a horizontal Hall element which detects a magnetic field in a vertical direction to a magnetoelectric conversion surface, the present embodiment is not limited to it. The magnetoelectric conversion element may be a vertical Hall element which detects a magnetic field in a horizontal direction to a magnetoelectric conversion surface.

[Second Embodiment]

A description has been made so far regarding the configuration in which the change in the magnetoelectric conversion coefficient KH of the Hall element H1 due to the stress such as a stress or the like is suppressed by the resistors R1 and R2. A description will next be made about the configuration of a magnetic sensor circuit 100a which generates a binary digital signal, based on the signals provided from the Hall element H1. Incidentally, the same configurations and operations as those in the above first embodiment are denoted by the same reference numerals, and their description will be omitted.

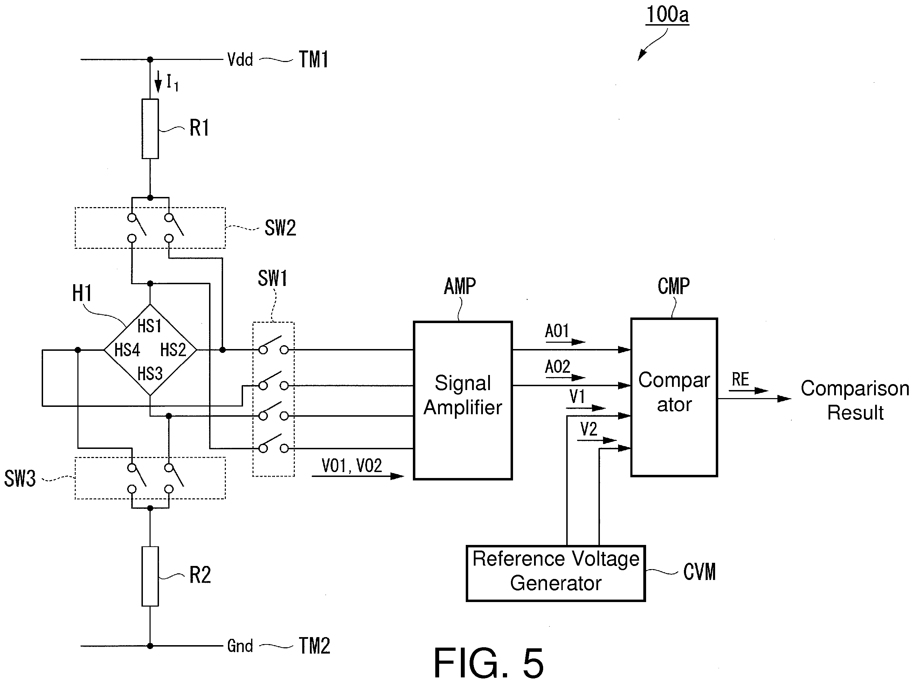

A circuit configuration of the magnetic sensor circuit 100a will next be described with reference to FIG. 5.

FIG. 5 is a circuit diagram illustrating one example of the configuration of the magnetic sensor circuit 100a according to the second embodiment.

The magnetic sensor circuit 100a is further equipped with an amplifier circuit AMP, a reference voltage generator CVM, and a comparator CMP.

The amplifier circuit AMP is connected to a first switch circuit SW1 and the reference voltage generator CVM.

The reference voltage generator CVM is connected to the comparator CMP.

The comparator CMP is connected to the amplifier circuit AMP and the reference voltage generator CVM.

The amplifier circuit AMP amplifies a differential voltage provided from the Hall element H1. The amplifier circuit AMP outputs a post-amplification signal being the amplified differential voltage. Specifically, the amplifier circuit AMP acquires a signal VO1 and a signal VO2 from the first switch circuit SW1. The amplifier circuit AMP amplifies the signals VO1 and VO2 acquired from the first switch circuit SW1, respectively. The amplifier circuit AMP outputs a post-amplification signal AO1 and a post-amplification signal AO2 being the amplified signals to the comparator CMP.

The reference voltage generator CVM generates a first reference voltage V1 and a second reference voltage V2. Here, the first reference voltage V1 is a positive voltage. The second reference voltage V2 is a negative voltage.

The reference voltage generator CVM outputs the so-generated first and second reference voltages V1 and V2 to the comparator CMP, respectively.

The comparator CMP compares the reference voltage provided from the reference voltage generator CVM and the post-amplification signal provided from the amplifier circuit AMP and thereby outputs a comparison result therefrom. Specifically, the comparator CMP acquires the post-amplification signal AO1 and the post-amplification signal AO2 from the amplifier circuit AMP. The comparator CMP acquires the first reference voltage V1 and the second reference voltage V2 from the reference voltage generator CVM. The comparator CMP compares the magnitudes of the voltages of the so-acquired post-amplification signals AO1 and AO2 and the magnitude of the voltages of the so-acquired first and second reference voltages V1 and V2, respectively. The comparator CMP outputs a digital signal, based on the comparison result. In the present embodiment, the comparator CMP outputs a digital signal of 0 or 1.

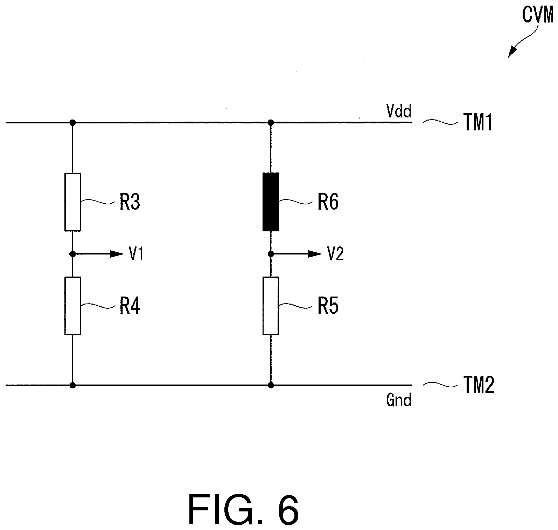

A circuit configuration of the reference voltage generator CVM will be described here with reference to FIG. 6.

FIG. 6 is a circuit diagram of the reference voltage generator CVM.

The reference voltage generator CVM is comprised of at least two types of resistors different from each other in temperature characteristic and generates a reference voltage. Specifically, the reference voltage generator CVM has at least one resistor having a first temperature characteristic. Further, the reference voltage generator CVM has resistors each having a temperature characteristic different from the first temperature characteristic. More specifically, the reference voltage generator CVM has a resistor R3, a resistor R4, a resistor R5, and a resistor R6. Here, the resistor R3, the resistor R4, and the resistor R5 respectively have a temperature coefficient of a temperature characteristic, which is similar to that of each of the above-described resistors R1 and R2. The resistor R6 has a temperature coefficient of a temperature characteristic, which is different from that of each of the above-described resistors R1 through R5. In the following description, the temperature characteristic of the resistor R6 is also described as a second temperature characteristic.

The resistor R3 is connected to the power supply terminal TM1 and the resistor R4. The resistor R4 is connected to the resistor R3 and the ground terminal TM2. That is, the resistor R3 having the first temperature characteristic, and the resistor R4 having the first temperature characteristic are connected in series to a path for a current applied to the reference voltage generator CVM. A voltage between the resistor R3 and the resistor R4 is a first reference voltage V1.

The resistor R5 is connected to the resistor R6 and the ground terminal TM2. The resistor R6 is connected to the power supply terminal TM1 and the resistor R5. That is, the resistor R5 having the first temperature characteristic, and the resistor R6 having the second temperature characteristic are connected in series to the path for the current applied to the reference voltage generator CVM. A voltage between the resistors R6 and R5 is a second reference voltage V2.

The first reference voltage V1 and the second reference voltage V2 can be represented by equation (8):

[Equation 8]

$$V_{REF} = V_1 - V_2$$
$$= V_{dd} \times \left[ \frac{Rb4}{Rb3 + Rb4} - \frac{Rb5}{Rb5 + Ra1} \right] \quad \cdot\cdot\cdot (8)$$

[Equation 9]

$$Rb3 = b3 \times Rtb, \quad Rb4 = b4 \times Rtb, \quad Rb5 = b5 \times Rtb, \quad Ra1 = a1 \times Rta$$

$$\cdots (9)$$

[Equation 10]

$$V_{REF} = V_1 - V_2$$
$$= V_{dd} \times \left[ \frac{b4}{b3 + b4} - \frac{b5 \cdot Rtb}{b5 \cdot Rtb + a1 \cdot Rta} \right] \quad \cdots (10)$$

Here, VREF is a voltage difference between the first reference voltage V1 and the second reference voltage V2. Since the Hall output is a differential signal, the reference voltage is described as a differential voltage composed of V1 and V2. Further, Rb3 is a resistance value of the resistor R3, Rb4 is a resistance value of the resistor R4, Rb5 is a resistance value of the resistor R5, and Ra1 is a resistance value of the resistor R6. b3, b4, b5, and a1 are respectively basic resistance values made by removing temperature dependency from the resistance values Rb3, Rb4, Rb5, and Ra1. Rtb is a temperature coefficient included in each of the resistors R3, R4, and R5, and Rta is a temperature coefficient of the resistor R6. In other words, Rtb is the temperature coefficient of the first temperature characteristic, and Rta is the temperature coefficient of the second temperature characteristic.

Here, when the temperature coefficient of the first temperature characteristic Rtb increases by a stress, the value (11) to be described later included in the equation (8) becomes large. The reference voltage VREF decreases with the increase in the value (11).

[Equation 11]

$$\left[ \frac{b4}{b3 + b4} - \frac{b5 \cdot Rtb}{b5 \cdot Rtb + a1 \cdot Rta} \right] \quad \cdots (11)$$

[Summary of Second Embodiment]

As described above, the magnetic sensor circuit 100a has the amplifier circuit AMP, the reference voltage generator CVM, and the comparator CMP. The amplifier circuit AMP outputs the post-amplification signal AO1 and the post-amplification signal AO2 respectively obtained by amplifying the signals VO1 and VO2 provided from the Hall element H1. The reference voltage generator CVM generates the first reference voltage V1 and the second reference voltage V2. The comparator CMP compares the post-amplification signals AO1 and AO2 and the first and second reference voltages V1 and V2 respectively to thereby output the digital signal.

The resistors R1 and R2 illustrated in FIG. 5 and the resistors R3, R4, and R5 illustrated in FIG. 6 are resistances having the same temperature coefficient as the first temperature coefficient Rtb. When the first temperature coefficient Rtb increases by the stress, the reference voltage generator CVM reduces the reference voltage VREF as described regarding the value (11). On the other hand, since the output voltage of the Hall element H1 is expressed by the magnetoelectric conversion coefficient KH of the equation (6), the magnetoelectric conversion coefficient KH is shifted in its decreasing direction where the first temperature coefficient Rtb increases. Thus, even when the resistances denoted by, for example, R1, R2, R3, R4, and R5 other than the resistance of the Hall element H1 itself uniformly changes by the stress, it is possible to reduce an error in the detection point of a magnetic sensor (caused by the comparator CMP in the present example) even if devices (resistors R1, R2, R3, R4, R5, and R6 in the present example) other than the Hall element H1 vary by the stress by making the signs of the amounts of variations in the output voltage provided from the Hall element H1 and the reference voltage VREF coincide.

That is, the reference voltage generator CVM generates reference voltages each having a prescribed temperature coefficient by combining a plurality of resistors having temperature coefficients different from each other. By using the resistor having the same temperature coefficient as that of the first resistor for at least one of the plural resistors which configure the reference voltage generator CVM, a shift in the reference voltage and a shift in the differential voltage provided from the Hall element H1 cooperate with each other. The comparator CMP is capable of suppressing the measurement error by cooperative shifting of the reference voltage being the base of the detection and the differential voltage provided from the Hall element H1, thereby suppressing the error in the magnetic sensor circuit.

Although the embodiments of the present invention and their modifications have been described above, these embodiments and their modifications have been presented as examples and are not intended to limit the scope of the invention. These embodiments and their modifications can be implemented in various other forms, and various omissions, substitutions and modifications can be made within a scope not departing from the invention. These embodiments and their modifications are included in the scope of the invention and also included in the invention described in the scope of the appended claims and within the scope of equivalency thereof. Further, the above-described embodiments and their modifications can be appropriately combined with each other.

**Claims**

1. A magnetic sensor circuit (100) comprising:

   a magnetoelectric conversion element (H1) having a plurality of terminals (HS1-HS4) including at least a voltage supply terminal to which a drive voltage (Vdd) is applied, and a ground terminal;
   a switch circuit (SW1) configured to output signals provided from any two of the plurality of terminals as a differential voltage;
   a first resistor (R1, R2) having a first temperature characteristic;
   a current supplied from the voltage supply terminal flowing to the ground terminal through the first resistor and the magnetoelectric conversion element;
   a reference voltage generator (CVM) having at least two types of resistors different in temperature characteristic from each other for generating a reference voltage, wherein the reference voltage generator includes:

   a resistor (R5) having the first temperature characteristic, and
   a resistor (R6) having a second temperature characteristic being a temperature characteristic different from the first temperature characteristic,
   **characterised in that** the resistor having the first temperature characteristic, and the resistor having the second temperature characteristic are connected in series to a path for a current applied to the reference voltage generator, and a voltage between the resistor having the first temperature characteristic and the resistor having the second temperature characteristic is generated as the reference voltage;

   an amplifier circuit (AMP) configured to amplify the differential voltage provided from the magnetoelectric conversion element and to output a post-amplification signal being the differential voltage amplified; and
   a comparator (CMP) configured to compare the reference voltage provided from the reference voltage generator and the post-amplification signal provided from the amplifier circuit to output a comparison result.

2. The magnetic sensor circuit according to claim 1, further comprising:

   a second switch circuit (SW2) configured to select one of the plurality of terminals into which the current flows; and
   a third switch circuit (SW3) configured to select a terminal opposing to the one of the plurality of terminals out of which the current flows,
   wherein the current further flows to the ground terminal through the one of the plurality of terminals selected by the second switch circuit and the terminal selected by the third switch circuit.

3. The magnetic sensor circuit according to claim 1 or claim 2, further comprising a second resistor (R2) having the first temperature characteristic,
   wherein the current further flows to the ground terminal through the second resistor.

4. The magnetic sensor circuit according to any one of the preceding claims, wherein a temperature coefficient of the first temperature characteristic is smaller than a temperature coefficient of a resistance value of the magnetoelectric conversion element.

5. The magnetic sensor circuit according to any one of the preceding claims, wherein the magnetoelectric conversion element is a horizontal Hall element (H1) configured to detect a magnetic field in a vertical direction to a magnetoelectric conversion surface, or a vertical Hall element configured to detect a magnetic field in a horizontal direction to the magnetoelectric conversion surface.

**Patentansprüche**

1. Magnetsensorschaltung (100), umfassend:

ein magnetoelektrisches Umwandlungselement (H1) mit einer Vielzahl von Anschlüssen (HS1-HS4), enthaltend zumindest einen Spannungsversorgungsanschluss, an den eine Treiberspannung (Vdd) angelegt wird, und einen Masseanschluss;

einen Umschalter (SW1), der konfiguriert ist, Signale, die von beliebigen zwei der Vielzahl von Anschlüssen bereitgestellt werden, als Differentialspannung auszugeben;

einen ersten Widerstand (R1, R2) mit einer ersten Temperatureigenschaft;

einen Strom, der vom Spannungsversorgungsanschluss zugeleitet wird, der durch den ersten Widerstand und das magnetoelektrische Umwandlungselement zum Massenanschluss fließt;

einen Referenzspannungsgenerator (CVM) mit zumindest zwei Arten von Widerständen, die sich in Temperatureigenschaft voneinander unterscheiden, zum Erzeugen einer Referenzspannung, wobei der Referenzspannungsgenerator enthält:

einen Wiederstand (R5) mit der ersten Temperatureigenschaft; und

einen Widerstand (R6) mit einer zweiten Temperatureigenschaft, die eine Temperatureigenschaft ist, die sich von der ersten Temperatureigenschaft unterscheidet,

**dadurch gekennzeichnet, dass**

der Widerstand mit der ersten Temperatureigenschaft und der Widerstand mit der zweiten Temperatureigenschaft in Reihe mit einem Pfad für einen Strom verbunden sind, der an den Referenzspannungsgenerator angelegt wird, und eine Spannung zwischen dem Widerstand mit der ersten Temperatureigenschaft und dem Widerstand mit der zweiten Temperatureigenschaft als die Referenzspannung erzeugt wird;

eine Verstärkungsschaltung (AMP), die konfiguriert ist die Differentialspannung, die vom magnetoelektrischen Umwandlungselement bereitgestellt wird zu verstärken und ein Signal nach Verstärkung auszugeben, das die verstärkte Differentialspannung ist; und

einen Komparator (CMP), der konfiguriert ist, die Referenzspannung, die vom Referenzspannungsgenerator erzeugt wird, und das Signal nach Verstärkung, das von der Verstärkerschaltung bereitgestellt wird, zu vergleichen, um ein Vergleichsergebnis auszugeben.

2. Magnetsensorschaltung nach Anspruch 1, ferner umfassend:

einen zweiten Umschalter (SW2), der konfiguriert ist, einen der Vielzahl von Anschlüssen auszuwählen, in die der Strom fließt; und

einen dritten Umschalter (SW3), der konfiguriert ist, einen Anschluss gegenüber dem einen der Vielzahl von Anschlüssen auszuwählen, aus welchem der Strom fließt, wobei der Strom durch den einen der Vielzahl von Anschlüssen, der durch den zweiten Umschalter ausgewählt wird, und den Anschluss, der durch den dritten Umschalter ausgewählt wird, weiter zum Masseanschluss fließt.

3. Magnetsensorschaltung nach Anspruch 1 oder Anspruch 2, ferner umfassend einen zweiten Widerstand (R2) mit der ersten Temperatureigenschaft,
wobei der Strom durch den zweiten Widerstand weiter zum Massenanschluss fließt.

4. Magnetsensorschaltung nach einem der vorstehenden Ansprüche, wobei ein Temperaturkoeffizient der ersten Temperatureigenschaft kleiner als ein Temperaturkoeffizient eines Widerstandswerts des magnetoelektrischen Umwandlungselements ist.

5. Magnetsensorschaltung nach einem der vorstehenden Ansprüche, wobei das magnetoelektrische Umwandlungselement ein horizontales Hall-Element (H1) ist, das konfiguriert ist, ein Magnetfeld in einer vertikalen Richtung zu einer magnetoelektrischen Umwandlungsfläche zu erfassen, oder ein vertikales Hall-Element, das konfiguriert ist, ein Magnetfeld in einer horizontalen Richtung zur magnetoelektrischen Umwandlungsfläche zu erfassen.

**Revendications**

1. Circuit de capteur magnétique (100) comprenant :

un élément de conversion magnétoélectrique (H1) ayant une pluralité de bornes (HS1-HS4) comprenant au moins une borne d'alimentation en tension à laquelle une tension de commande (Vdd) est appliquée, et une borne de masse ;
un circuit de commutation (SW1) configuré pour faire sortir des signaux fournis par deux quelconques parmi la pluralité des bornes en tant que tension différentielle ;
une première résistance (R1, R2) ayant une première caractéristique de température ;
un courant alimenté à partir de la borne d'alimentation en tension circulant vers la borne de masse à travers la première résistance et l'élément de conversion magnétoélectrique ;
un générateur de tension de référence (CVM) ayant au moins deux types de résistances différentes l'une de l'autre en caractéristique de température pour générer une tension de référence, dans lequel le générateur de tension de référence comprend :

une résistance (R5) ayant la première caractéristique de température, et
une résistance (R6) ayant une deuxième caractéristique de température qui est une caractéristique de température différente de la première caractéristique de température,
**caractérisé en ce que**
la résistance ayant la première caractéristique de température et la résistance ayant la deuxième caractéristique de température sont connectées en série à un trajet pour un courant appliqué au générateur de tension de référence, et une tension entre la résistance ayant la première caractéristique de température et la résistance ayant la deuxième caractéristique de température est générée en tant que tension de référence ;
un circuit amplificateur (AMP) configuré pour amplifier la tension différentielle fournie par l'élément de conversion magnétoélectrique et pour faire sortir un signal de post-amplification qui est la tension différentielle amplifiée ; et
un comparateur (CMP) configuré pour comparer la tension de référence fournie par le générateur de tension de référence et le signal de post-amplification fourni par le circuit amplificateur pour faire sortir un résultat de comparaison.

2. Circuit de capteur magnétique selon la revendication 1, comprenant en outre :

un deuxième circuit de commutation (SW2) configuré pour sélectionner l'une de la pluralité des bornes dans lesquelles le courant circule ; et
un troisième circuit de commutation (SW3) configuré pour sélectionner une borne opposée à celle de la pluralité des bornes hors de laquelle le courant circule,
dans lequel le courant circule en outre vers la borne de masse à travers cette borne de la pluralité des bornes sélectionnée par le deuxième circuit de commutation et la borne sélectionnée par le troisième circuit de commutation.

3. Circuit de capteur magnétique selon la revendication 1 ou la revendication 2, comprenant en outre une deuxième résistance (R2) ayant la première caractéristique de température,
dans lequel le courant circule en outre vers la borne de masse à travers la deuxième résistance.

4. Circuit de capteur magnétique selon l'une quelconque des revendications précédentes, dans lequel un coefficient de température de la première caractéristique de température est inférieur à un coefficient de température d'une valeur de résistance de l'élément de conversion magnétoélectrique.

5. Circuit de capteur magnétique selon l'une quelconque des revendications précédentes, dans lequel l'élément de conversion magnétoélectrique est un élément de Hall horizontal (HI) configuré pour détecter un champ magnétique dans une direction verticale par rapport à une surface de conversion magnétoélectrique, ou un élément de Hall vertical configuré pour détecter un champ magnétique dans une direction horizontale par rapport à la surface de conversion magnétoélectrique.

FIG. 1

First Phase

Second Phase

FIG. 2A

FIG. 2B

FIG. 3

FIG. 4

FIG. 5

FIG. 6

**REFERENCES CITED IN THE DESCRIPTION**

**Patent documents cited in the description**

- JP 2014517919 A
- US 8723515 B
- US 2013057084 A
- US 2010109661 A